# FASCICULE DE BREVET EUROPEEN

(11) **EP 3 078 245 B1**
(45) Date de publication et mention de la délivrance du brevet: **26.04.2017**
(21) Numéro de dépôt: 14802673.5
(22) Date de dépôt: 26.11.2014
(51) Int. Cl.: H05K 1/02

(54) **PROCEDE DE FABRICATION D'UN CIRCUIT IMPRIME DE PUISSANCE ET CIRCUIT IMPRIME DE PUISSANCE OBTENU PAR CE PROCEDE**
VERFAHREN ZUR HERSTELLUNG EINER GEDRUCKTEN LEISTUNGSSCHALTUNG UND NACH DIESEM VERFAHREN HERGESTELLTE GEDRUCKTE LEISTUNGSSCHALTUNG
METHOD FOR PRODUCING A POWER PRINTED CIRCUIT AND POWER PRINTED CIRCUIT OBTAINED BY THIS METHOD

(30) Priorité: 02.12.2013 FR 1361936
(43) Date de publication de la demande: 12.10.2016
(73) Titulaire: Delphi France SAS, 95972 Roissy CDG Cedex (FR)
(72) Inventeur: PETITGAS, Jérôme, F-77230 Moussy le Neuf (FR); SLEZAK, René, F-92500 Rueil Malmaison (FR)
(74) Mandataire: Delphi France SAS
(86) Numéro de dépôt international: PCT/EP2014/075615
(87) Numéro de publication internationale: WO 2015/082267

(56) Documents cités:
- FR-A1- 2 509 564
- FR-A1- 2 908 587
- JP-A- H1 118 251
- US-B1- 6 221 514

## Description

L'invention concerne le domaine des circuits imprimés de puissance et leurs procédés de fabrication.

Les circuits imprimés de puissance ont de nombreuses applications dans le domaine de l'électronique de puissance, et notamment dans le domaine automobile. Ils peuvent être utilisés par exemple dans des convertisseurs pour dispositifs de traction électrique.

Un circuit imprimé comporte généralement un substrat isolant, par exemple en verre-epoxy, supportant une couche conductrice, par exemple en cuivre, dans laquelle sont réalisées les pistes conductrices d'un circuit électrique ou électronique. Pour passer de forts courants dans ces pistes, on peut envisager d'augmenter la largeur et/ou l'épaisseur de ces pistes. Mais ce n'est parfois pas suffisant ou pas compatible avec les dimensions requises pour le circuit. Une autre solution consiste à utiliser une plaque ou grille de matériau électriquement conducteur (« leadframe » selon la terminologie anglo-saxonne) ou un bus bar (aussi appelé « barre omnibus ») connecté aux pistes du circuit imprimé. Cette connexion peut être réalisée par vissage, brasure, emmanchement à force (« press fit » selon la terminologie anglo-saxonne), dépôt de cuivre chimique (vias) ou soudure. Plusieurs types de soudure sont envisagés dans le document WO 2009/121697 A1, comme notamment la soudure à l'étain, avec de la pâte de soudure ou la soudure au laser. FR2509564 proposé le procédé de fabrication d'un circuit électrique dans lequel on fournit un substrat électriquement isolant muni d'une piste de matériau électriquement conducteur, ainsi qu'un bus bar et dans lequel on soude par laser. Un but de l'invention consiste à fournir un procédé industriel rapide et fiable, permettant de souder des bus bars avec le moins possible de limitations quant aux dimensions de celui-ci.

A cette fin, il est proposé un procédé de fabrication d'un circuit électrique de puissance dans lequel on fournit, d'une part, un substrat électriquement isolant muni d'une piste de matériau électriquement conducteur (ou piste conductrice) et, d'autre part, un bus bar. Selon ce procédé on réalise une soudure par laser, au niveau d'un ou plusieurs points de soudure, entre le bus bar et la piste conductrice. Une épaisseur du bus bar, au point de soudure, inférieure à deux fois l'épaisseur de la piste conductrice permet de réaliser relativement aisément une soudure par laser fiable.

Ce procédé est tout à fait intéressant industriellement, ainsi qu'au plan économique. En effet, la technologie de soudure par laser permet une mise en oeuvre industrielle, précise, propre, flexible, économique et avec des cadences élevées. La flexibilité de cette technologie permet de s'adapter à de nombreux types et épaisseurs de matériau. Par exemple, l'épaisseur de la piste conductrice peut être inférieure à 500µm.

La mise en oeuvre de cette technologie peut être facilitée en réalisant une restriction d'épaisseur du bus bar au niveau du point de soudure et/ou en soudant un premier bus bar sur la piste conductrice dont l'épaisseur au point de soudure est inférieure à deux fois l'épaisseur de la piste conductrice, et en soudant ou en connectant (avant ou après le soudage du premier bus bar sur la piste conductrice) au moins un deuxième bus bar sur le premier bus bar. Par exemple, dans ce cas, le premier bus bar a une épaisseur inférieure ou sensiblement égale à 400µm et le deuxième bus bar a une épaisseur supérieure ou sensiblement égale à 400µm.

Selon un autre aspect, l'invention concerne un circuit électrique obtenu par ce procédé.

D'autres caractéristiques et avantages de l'invention apparaîtront à la lecture de la description détaillée qui suit ainsi que sur les dessins annexés. Sur ces dessins :
la figure 1 représente schématiquement en coupe un mode de réalisation d'un circuit électrique selon l'invention; et
la figure 2 représente schématiquement en coupe un autre mode de réalisation d'un circuit électrique selon l'invention.

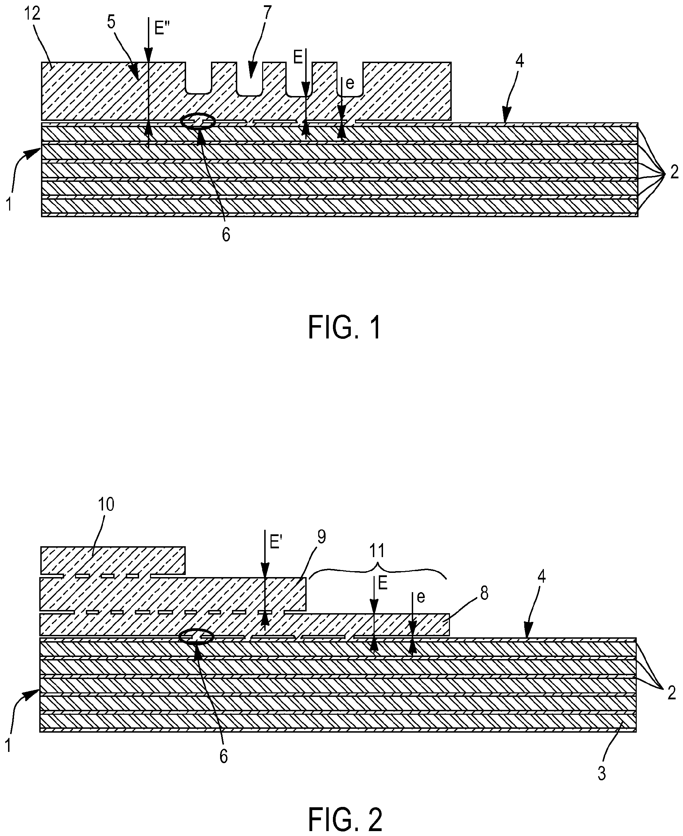

Selon un premier mode de mise en oeuvre, le procédé selon l'invention consiste à souder par laser un bus bar sur un circuit électrique imprimé, au niveau de restrictions réalisées dans l'épaisseur du bus bar. Un exemple de circuit électrique obtenu par ce procédé est illustré sur la figure 1.

Plus particulièrement, selon ce mode de mise en oeuvre, on fournir un substrat 1 de matériau isolant pour circuit imprimé. Ce substrat 1 peut comporter une ou plusieurs couches 2 de matériau électriquement conducteur. Chacune de ces couches repose sur un matériau électriquement isolant 3. Le matériau électriquement conducteur de chacune de des couches de matériau électriquement conducteur, et notamment de la couche superficielle ou piste conductrice 4, est par exemple constitué de cuivre sous forme d'une feuille dont l'épaisseur est comprise entre 75µm et 105µm. Le matériau isolant est par exemple du verre époxy.

Un bus bar ou élément de bus bar 5 (« bus bar » pour simplifier) est ensuite fourni pour être raccordé électriquement à la piste conductrice 4. Ce bus bar est constitué d'un matériau électriquement bon conducteur en cuivre ou en alliage de cuivre ou d'aluminium. L'épaisseur du bus bar est par exemple de 1000µm.

La liaison ou raccordement électrique entre le bus bar 5 et la piste conductrice 4 est réalisée par soudage au laser. Le soudage au laser est réalisé en un ou plusieurs points de soudure 6. Chaque point de soudure 6 est réalisé au niveau d'une restriction 7 de l'épaisseur du bus bar 5. Ces restrictions 7 d'épaisseur ont par exemple la forme d'un puits ou d'une rainure, ramenant l'épaisseur du bus bar 5, au fond de chaque restriction 7, à une épaisseur proche de celle de la piste conductrice 4. Le rapport de l'une de ces épaisseurs par rapport à l'autre est avantageusement inférieur à deux. Par exemple, l'épaisseur E du bus bar 7 au fond de la restriction a au plus deux fois l'épaisseur e de la piste conductrice 4.

Les restrictions 7 peuvent être réalisées par emboutissage, gravure, etc.

Selon une variante non illustrée, le ou les point(s) de soudure sont réalisés sur des zones d'épaisseur moindre (en plus ou à la place des restrictions décrites ci-dessus) telles que des biseaux.

On a ainsi mixé deux technologies : celle des circuits électriques/électroniques de faible puissance avec celle des circuits (bus bars) de forte puissance. Ainsi, un obtient un circuit imprimé avec un bus bar 5 avec une zone épaisse 12, d'épaisseur E" supérieure à l'épaisseur E, pour conduire de forts courants et des zones moins épaisses au niveau des restrictions 7 pour permettre une soudure par laser du bus bar 5 sur la piste conductrice 4.

Selon un deuxième mode de mise en oeuvre, le procédé selon l'invention consiste à souder par laser un bus bar sur un circuit électrique imprimé, puis de relier électriquement ce bus bar à un ou plusieurs autres bus bars. Un exemple de circuit électrique obtenu par ce procédé est illustré sur la figure 2.

Comme pour le premier mode de mise en oeuvre, on fournit un substrat 1 de matériau électriquement isolant, avec une couche superficielle ou piste conductrice 4 de matériau électriquement conducteur. Une ou plusieurs autres couches 2 de matériau électriquement conducteur peuvent être intercalées dans l'épaisseur du substrat 1. On fournit également un premier bus bar 8 que l'on soude sur la piste conductrice 4. La nature des matériaux constitutifs respectivement du substrat 1, des couches 2, 4 de matériau électriquement conducteur, du matériau électriquement isolant 3 et du bus bar 5 est choisie parmi celles mentionnées en relation avec le premier mode de mise en oeuvre du procédé selon l'invention. Le premier bus bar 8 est de relativement faible épaisseur. Par exemple cette épaisseur est de 400µm pour une épaisseur de 200µm de la piste conductrice 4. L'épaisseur E du premier bus bar 8 au point de soudure 6 est inférieure ou égale à deux fois l'épaisseur e de la piste 4. Un soudage par laser est réalisé en un ou plusieurs points de soudure 6. Un deuxième bus bar 9, plus épais, est ensuite connecté sur le premier bus bar 8. Le deuxième bus bar 9 a par exemple une épaisseur E' supérieure à 400µm, par exemple 600µm, voire 800µm ou plus. La connexion électrique entre les premier 8 et deuxième 8 bus bars peut être réalisé par soudure (au laser ou non). Le fait de ne pas avoir de matériau isolant fragile directement sous-jacent et/ou d'avoir déjà une couche relativement épaisse de matériau électriquement et thermiquement conducteur (premier bus bar) pour évacuer l'énergie permet éventuellement d'utiliser de plus fortes énergies et/ou températures.

Eventuellement, un troisième 10, quatrième, etc. bus bar peut-être de manière similaire connectée électriquement aux bus bars déjà reliés au circuit imprimé constitué du substrat 1 et de la piste conductrice 4.

Eventuellement, les bus bars sont empilés et fixés les uns aux autres au cours d'étapes antérieures et une zone de moindre épaisseur 11 est ménagée pour pouvoir réaliser une soudure au laser sur la piste conductrice 4.

## Revendications

1. Procédé de fabrication d'un circuit électrique dans lequel on fournit un substrat (1) électriquement isolant muni d'une piste (4) de matériau électriquement conducteur, ainsi qu'un bus bar (5) et dans lequel on soude par laser, en au moins un point de soudure (6), le bus bar (5 ou 8) sur la piste (4) de matériau électriquement conducteur, où l'épaisseur (E) du bus bar (5 ou 8) au point de soudure (6) est inférieure à deux fois l'épaisseur (e) de la piste (4) de matériau électriquement conducteur, **caractérisé par le fait qu'**on réalise une restriction (7) d'épaisseur du bus bar (5) au niveau du point de soudure (6)

2. Procédé selon la revendication 1, dans lequel l'épaisseur (e) de la piste (4) de matériau électriquement conducteur est inférieure à 500µm.

3. Procédé selon l'une des revendications précédentes, dans lequel on soude un premier bus bar (8) sur la piste (4) de matériau électriquement conducteur dont l'épaisseur (E) au point de soudure (6) est inférieure à deux fois l'épaisseur (e) de la piste (4) de matériau électriquement conducteur et on soude ou on connecte au moins un deuxième bus bar (9) sur le premier bus bar (8).

4. Procédé selon la revendication 3, dans lequel le premier bus bar (8) a une épaisseur (E) inférieure ou sensiblement égale à 400µm et le deuxième bus bar (9) a une épaisseur (E') supérieure ou sensiblement égale à 400µm.

5. Circuit électrique comprenant un substrat (1) électriquement isolant muni d'une piste (4) de matériau électriquement conducteur, ainsi qu'un bus bar (5 ou 8) soudé par laser, en au moins un point de soudure (6), sur la piste (4) de matériau électriquement conducteur où l'épaisseur (E) du bus bar (5 ou 8) au point de soudure (6) est inférieure à deux fois l'épaisseur (e) de la piste (4) de matériau électriquement conducteur, **caractérisé par le fait que** le bus bar (5) comporte au moins une restriction (7) d'épaisseur au niveau du point de soudure.

6. Circuit électrique selon la revendication 5, dans lequel l'épaisseur (e) de la piste (4) de matériau électriquement conducteur est inférieure à 500µm.

7. Circuit électrique selon l'une des revendications 5 à 6, comportant un premier bus bar (8) soudé en au moins un point de soudure (6) sur la piste (4) de matériau électriquement conducteur et dont l'épaisseur (E) est inférieure à deux fois l'épaisseur (e) de la piste (4) de matériau électriquement conducteur et dans lequel au moins un deuxième bus bar (9) est connecté ou soudé sur le premier bus bar (8).

8. Circuit électrique selon la revendication 7, dans lequel le premier bus bar (8) a une épaisseur (E) inférieure ou sensiblement égale à 400µm et le deuxième bus bar a une épaisseur (E') supérieure ou sensiblement égale à 400µm.

## Patentansprüche

1. Verfahren zum Herstellen eines elektrischen Schaltkreises, bei dem ein elektrisch isolierendes Substrat (1) bereitgestellt wird, das mit einer Leiterbahn (4) aus elektrisch leitendem Material versehen ist, sowie eine Sammelschiene (5), wobei an zumindest einem Schweißpunkt (6) die Sammelschiene (5 bzw. 8) an die Leiterbahn (4) aus elektrisch leitendem Material mittels Laser angeschweißt wird,
wobei die Dicke (E) der Sammelschiene (5 bzw. 8) am Schweißpunkt (6) geringer ist als die zweifache Dicke (e) der Leiterbahn (4) aus elektrisch leitendem Material,
**dadurch gekennzeichnet, dass**
im Bereich des Schweißpunkts (6) eine Begrenzung (7) der Dicke der Sammelschiene (5) erfolgt.

2. Verfahren nach Anspruch 1, wobei die Dicke (e) der Leiterbahn (4) aus elektrisch leitendem Material geringer als 500 µm ist.

3. Verfahren nach einem der vorangehenden Ansprüche, wobei eine erste Sammelschiene (8) an die Leiterbahn (4) aus elektrisch leitendem Material angeschweißt wird, deren Dicke (E) am Schweißpunkt (6) geringer als die zweifache Dicke (e) der Leiterbahn (4) aus elektrisch leitendem Material ist, und zumindest eine zweite Sammelschiene (9) an die erste Sammelschiene (8) angeschweißt bzw. mit dieser verbunden wird.

4. Verfahren nach Anspruch 3, wobei die erste Sammelschiene (8) eine Dicke (E) hat, die geringer oder im Wesentlichen gleich 400 µm ist, und die zweite Sammelschiene (9) eine Dicke (E') hat, die größer oder im Wesentlichen gleich 400 µm ist.

5. Elektrischer Schaltkreis, enthaltend ein elektrisch isolierendes Substrat (1), das mit einer Leiterbahn (4) aus elektrisch leitendem Material versehen ist, sowie eine Sammelschiene (5 bzw. 8), die an zumindest einem Schweißpunkt (6) an die Leiterbahn (4) aus elektrisch leitendem Material mittels Laser angeschweißt ist,
wobei die Dicke (E) der Sammelschiene (5 bzw. 8) am Schweißpunkt (6) geringer ist als die zweifache Dicke (e) der Leiterbahn (4) aus elektrisch leitendem Material,
**dadurch gekennzeichnet, dass**
die Sammelschiene (5) im Bereich des Schweißpunkts zumindest eine Dickenbegrenzung (7) enthält.

6. Elektrischer Schaltkreis nach Anspruch 5, wobei die Dicke (e) der Leiterbahn (4) aus elektrisch leitendem Material geringer als 500 µm ist.

7. Elektrischer Schaltkreis nach einem der Ansprüche 5 bis 6, enthaltend eine erste Sammelschiene (8), die an zumindest einem Schweißpunkt (6) an die Leiterbahn (4) aus elektrisch leitendem Material angeschweißt ist und deren Dicke (E) geringer als die zweifache Dicke (e) der Leiterbahn (4) aus elektrisch leitendem Material ist, wobei zumindest eine zweite Sammelschiene (9) mit der ersten Sammelschiene (8) verbunden bzw. an diese angeschweißt ist.

8. Elektrischer Schaltkreis nach Anspruch 7, wobei die erste Sammelschiene (8) eine Dicke (E) hat, die geringer oder im Wesentlichen gleich 400 µm ist, und die zweite Sammelschiene eine Dicke (E') hat, die größer oder im Wesentlichen gleich 400 µm ist.

## Claims

1. A process for manufacturing an electrical circuit in which an electrically insulating substrate (1) equipped with a track (4) of electrically conductive material, and a bus bar (5) are provided and in which, at at least one weld spot (6), the bus bar (5 or 8) is welded by laser welding to the track (4) of electrically conductive material,
wherein the thickness (E) of the bus bar (5 or 8) at the weld spot (6) is smaller than two times the thickness (e) of the track (4) of electrically conductive material,
**characterized in that** a restriction (7) is produced in the thickness of the bus bar (5) level with the weld spot (6).

2. The process as claimed in claim 1, in which the thickness (e) of the track (4) of electrically conductive material is smaller than 500 µm.

3. The process as claimed in one of the preceding claims, in which a first bus bar (8) is welded to the track (4) of electrically conductive material, the thickness (E) of which, at the weld spot (6), is smaller than two times the thickness (e) of the track (4) of electrically conductive material, and at least one second bus bar (9) is welded or connected to the first bus bar (8).

4. The process as claimed in claim 3, in which the first bus bar (8) has a thickness (E) smaller than or substantially equal to 400 µm and the second bus bar (9) has a thickness (E') larger than or substantially equal to 400 µm.

5. An electrical circuit comprising an electrically insulating substrate (1) equipped with a track (4) of electrically conductive material, and a bus bar (5 or 8) that is welded by laser welding, at at least one weld spot (6), to the track (4) of electrically conductive material,
wherein the thickness (E) of the bus bar (5 or 8) at the weld spot (6) is smaller than two times the thickness (e) of the track (4) of electrically conductive material,
**characterized in that** the bus bar (5) includes at least one restriction (7) in its thickness level with the weld spot.

6. The electrical circuit as claimed in claim 5, in which the thickness (e) of the track (4) of electrically conductive material is smaller than 500 µm.

7. The electrical circuit as claimed in one of claims 5 to 6, including a first bus bar (8) welded, at at least one weld spot (6), to the track (4) of electrically conductive material, and the thickness (E) of which is smaller than two times the thickness (e) of the track (4) of electrically conductive material, and in which at least one second bus bar (9) is connected or welded to the first bus bar (8).

8. The electrical circuit as claimed in claim 7, in which the first bus bar (8) has a thickness (E) smaller than or substantially equal to 400 µm and the second bus bar has a thickness (E') larger than or substantially equal to 400 µm.
